(19) Europäisches Patentamt

European Patent Office

Office européen des brevets

(11) Publication number: **0 306 225 B1**

# EUROPEAN PATENT SPECIFICATION

(45) Date of publication of patent specification:
27.12.91 Bulletin 91/52

(51) Int. Cl.⁵: **H01S 3/19**, H01L 33/00,
H01L 21/306

(21) Application number: 88307899.0

(22) Date of filing: 25.08.88

(54) **Method of producing a semiconductor laser.**

(30) Priority: 28.08.87 JP 215586/87

(43) Date of publication of application:
08.03.89 Bulletin 89/10

(45) Publication of the grant of the patent:
27.12.91 Bulletin 91/52

(84) Designated Contracting States:
DE FR GB

(56) References cited:
EP-A- 0 155 151
EP-A- 0 209 194
US-A- 4 447 904
XEROX DISCLOSURE JOURNAL, vol. 11, no. 2,
March/April 1986, pages 97-100, Xerox Corp.,
Stamford, Conn., US; R.D. BURNHAM et al.:
"Semiconductor injection lasers with quan-
tum size effect transparent waveguiding"

(56) References cited:
IEEE ELECTRON DEVICE LETTERS, vol.
EDL-5, no. 8, August 1984, pages 306-309,
IEEE, New York, US; M.E. KIM et al.:
"GaAs/GaAlAs selective MOCVD epitaxy and
planar ion-implantation technique for complex
integrated optoelectronic circuit applications"
RCA REVIEW, vol. 39, no. 2, June 1978, pages
278-308, RCA Corp., Princeton, US; W. KERN:
"Chemical etching of silicon, germanium, gal-
lium arsenide, and gallium phosphide"
PATENT ABSTRACTS OF JAPAN, vol. 11, no.
275 (E-537)[2722], 5th September 1987; & JP-
A-62 73 691

(73) Proprietor: MITSUBISHI DENKI KABUSHIKI
KAISHA
2-3, Marunouchi 2-chome Chiyoda-ku
Tokyo 100 (JP)

(72) Inventor: Takami, Akihiro Mitsubishi Denki
LSI Kenkyusho, No. 1, Mizuhara 4-chome
Itami-shi Hyogo-ken (JP)

(74) Representative: Beresford, Keith Denis Lewis
et al
BERESFORD & Co. 2-5 Warwick Court High
Holborn
London WC1R 5DJ (GB)

## Description

FIELD OF THE INVENTION

The present invention relates to a method of producing a semiconductorlaser, and more particularly to that method capable of obtaining a semiconductor laser having a narrow emission beam and a high light output property by conducting film production at good controllability and uniform quality on a large area wafer.

BACKGROUND OF THE INVENTION

Recently, semiconductor lasers are often used as a light source in light communication, an optical disk, and a laser printer. For these laser elements, properties such as narrow emission beam, high output operation, low threshold current, and lengthy lifetime are strongly desired.

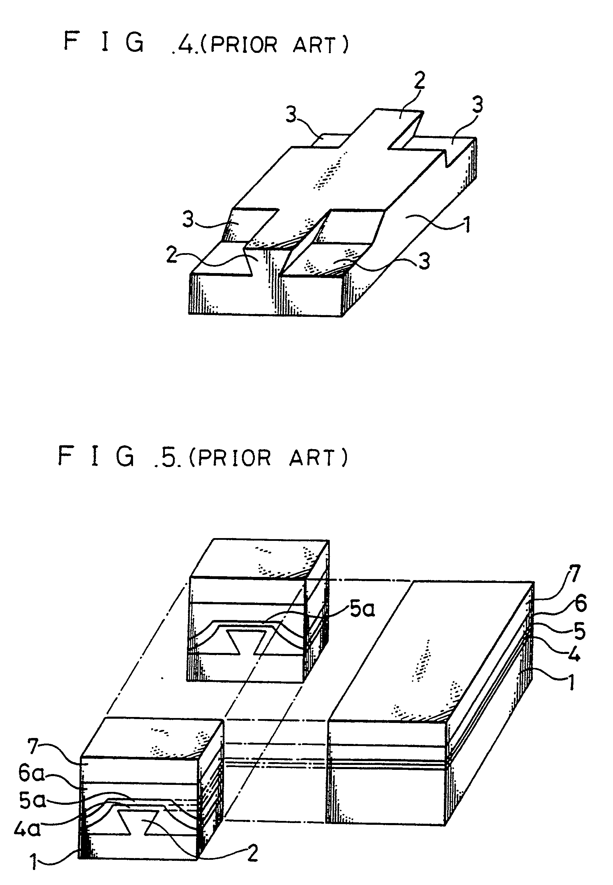

In order to improve these properties, a variety of kinds of lasers are proposed. Figure 4 shows an example of a substrate of such a semiconductor laser in its processed state and figure 5 shows a perspective view of a structure of a semiconductor laser which is obtained by conducting epitaxial growths of respective semiconductor layers successively on the substrate (EP-A-0155151). In figure 5, the center portion of the laser is cut and position shifted for easening the understanding.

In these figures, four grooves 3 are produced at the four corners of a GaAs substrate 1 by etching, and thus two ridges 2 are provided at the both end surfaces of the GaAs substrate 1. The reference numerals 4 and 4a designate lower cladding layers comprising n type $Al_xGa_{1-x}As$ which are produced at the central portion of the chip and on the ridges 2, respectively. The reference numerals 5 and 5a designate active layers comprising $Al_yGa_{1-y}As$ which are produced at the central portion of the chip and on the ridges 2, respectively. The reference numerals 6 and 6a designate upper cladding layers comprising p type $Al_xGa_{1-x}As$ which are produced at the central portion of the chip and on the ridges 2, respectively. The reference numeral 7 designates a p type GaAs contact layer.

The production method of this semiconductor laser will be described.

When $Al_xGa_{1-x}As$ is epitaxially grown on the substrate 1 of such a construction, a growth usually is conducted at the central portion of the chip where there is no groove 3 without being affected by the groove 3, but at the neighborhood of the chip end surface, a phenomenon peculiar to the liquid phase epitaxy (hereinafter referred to as "LPE method"). That is, in the LPE method the growth rate at the neighborhood of the side of the ridge 2 becomes faster than usual and that onto the ridge 2 becomes slower than usual dependent on the isotropicity of the crystal surface.

In the usual semiconductor laser, the thickness of the active layer is constant in the light emission direction, and when the thickness of the active layer is made thin uniformly in order to realize the narrow emission beam and high output operation, the gain is reduced thereby to increase the threshold current, and overheating occurs due to such as increase in the light power density and that in the light absorption at the neighborhood of the resonator end surface, thereby shortening the lifetime of the laser element. In the prior art device, however, the thickness of the active layer 5 at the inside and central portion of the chip which largely affects influences upon the lasing threshold current is made to be somewhat thick and only that at the neighborhood of the resonator end surface is made thin, whereby spreading of light into the upper and lower cladding layers 6a and 4a is increased and the light power density thereat is lowered. This and the accompanying reduction in the threshold current enable desired properties of lengthy lifetime, narrow emission beam, and high output operation.

In the prior art semiconductor laser of such a construction, the layer thickness of the active layer at the neighborhood of the resonator end surface is made thinner than that at the inside and central portion of the chip by utilizing that the growth rate of the semiconductor layer in the LPE method is slower at the ridge portion than at the plain portion. In the LPE method, however, there is a limitation in the widening of the wafer area and this method is not desirable in view of the enhancement in the reproducibility, production yield, and quality.

SUMMARY OF THE INVENTION

The present invention is intended as an alternative and improved method of production.

In accordance with the invention there is provided a method of producing a semiconductor laser comprising :
providing a semiconductor substrate ;
growing a support layer upon a surface of said substrate ;
growing a mask layer upon said support layer ;
etching said mask layer to leave a remanent portion thereof at at least one position proximate to that position of a light emission end surface of the laser to be produced ;
etching said support layer thereby to leave a part of said remanent portion of the mask layer overhanging said surface of said substrate ; and
growing successively a lower cladding layer, an active layer and an upper cladding layer on said substrate by metal-organic chemical vapour deposition, whereby a double-heterojunction structure laser is produced wherein the thickness of each of said lower cladding layer, active layer, and upper cladding layer is in each respective case less at the light emission end thereof than at the inside and central position of the laser.

While this method is being performed the circulation of gas is comparatively poor in that region that is beneath the overhanging mask layer. The amount of gas supplied to the adjacent re-entrant surface is thus reduced relative to the remainder surface and the film growth rate becomes slower. A doublehetero junction structure in which the thicknesses of the respective layers at the neighbourhood of the light emission end surface are thinner than those at the inside and central portion of the chip is thus obtained. This, as has been explained, results in the desired properties of lengthy lifetime, narrow beam emission, high output operation and a low threshold current. Since a metal-organic chemical vapour deposition technique is employed, the film production is readily controlled and can result in uniform film quality and a high production yield.

Figure 1 is a perspective view showing a semiconductor laser as an embodiment of the present invention ;

Figure 2 is a diagram showing cross-sectional views at major production processes thereof ;

Figure 3 is a perspective view showing a semiconductor laser as another embodiment of the present invention ;

Figure 4 is a perspective view showing a substrate of a prior art semiconductor laser ; and

Figure 5 is a perspective view showing a prior art semiconductor laser in a state where the central portion is cut and position shifted.

## DETAILED DESCRIPTION OF THE PREFERRED EMBODIMENTS

An embodiment of the present invention will be described with reference to the drawings.

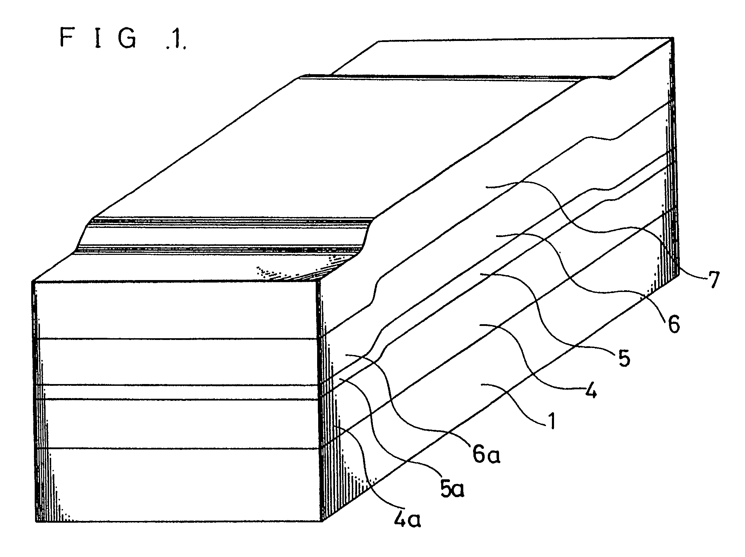

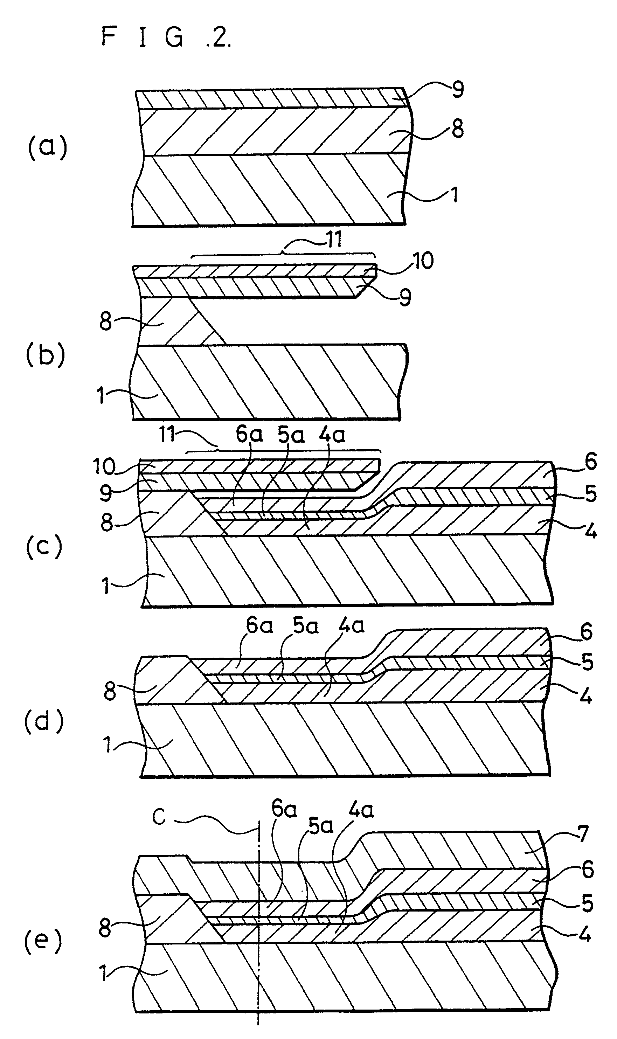

Figure 1 shows a semiconductor laser as an embodiment of the present invention and figure 2 shows the production process thereof in the order of the processing steps. The same reference numerals designate the same or corresponding elements as those shown in figure 1.

The reference numerals 8, 9, 10, and 11 designate layers constituting masks for producing the respective layers 4a to 6a. That is, the numeral 8 designates a support layer comprising n type $Al_xGa_{1-x}As$, the numeral 9 designates an n type GaAs mask layer, the numeral 10 designates a silicon dioxide film ($SiO_2$ film), and the numeral 11 designates an overhung portion comprising the mask layer 9 and the $SiO_2$ film 10, produced at the neighborhood of the light emission end surface.

The production process of the respective layers will be described with reference to figure 2.

Figure 2(a) :

1) A support layer 8 comprising n type $Al_xGa_{1-x}As$ is produced on the n type GaAs substrate 1 to a thickness of 2.5 to 3 $\mu$m and a mask layer 9 comprising n type GaAs is produced thereon to a thickness of about 0.5 $\mu$m both by an MOCVD method. (Metal organic chemical vapour deposition)

Figure 2(b) :

1) A $SiO_2$ film 10 is produced on the mask layer 9 by such as a thermal oxidation method to a thickness of about 1000 Å (10 Å = 1 nm).
2) A photoresist film (not shown) of about 5000 Å thickness is deposited thereon by a spinning method, a patterning for producing the semiconductor layers 4 to 6 and 4a to 6a is conducted to the $SiO_2$ film 10 by a photolithography technique, and an etching is conducted to the $SiO_2$ film 10.
3) The photoresist film is resolved to be removed.
4) The mask layer 9 is etched by ammonia hydrogen-peroxide water system etchant with the $SiO_2$ film 10 as mask.
5) The support layer 8 is etched by mixed solution of iodine and potassium iodide with the $SiO_2$ film 10 and the mask layer 9 as mask, and further side-etching is conducted to produce an overhung portion 11 comprising the $SiO_2$ film 10 and the mask layer 9 to a length of about 10 to 50 $\mu$m.

Figure 2(c) :

1) A cladding layer 4 comprising n type $Al_xGa_{1-x}As$ of 1.0 to 1.5 $\mu$m thickness, an active layer 5 comprising $Al_yGa_{1-y}As$ of 0.07 to 0.1 $\mu$m thickness, an upper cladding layer comprising p type $Al_xGa_{1-x}As$ of about 1 $\mu$m thickness are successively grown on the n type GaAs substrate 1 thereby to produce a doublehetero junction. Herein, the circulating of material gas into below the mask layer producing the overhung portion comprising the $SiO_2$ film 19 and the mask layer 9 is bad and the growth rate of the film is slower, whereby thin growth layers 4a to 6a having about 80% thicknesses of the respective layers 4 to 6 are produced. Herein, the respective layers will not be epitaxially grown on the $SiO_2$ film 10.

Figure 2(d)

1) The $SiO_2$ film 10 is etched to be removed by a dry etching using such as fluoro-carbon system gas.
2) The mask layer 9 is etched to be removed by an etching using ammonia hydrogen peroxide water series etchant.

Figure 2(e)

1) A p type GaAs contact layer 7 of 1 to 1.5 µm thickness is produced on the upper cladding layers 6 and 6a by an MOCVD method.

2) A laser chip is produced by cleaving at the cleavage lines.

In this embodiment, since an overhung portion comprising at least a support layer and a mask layer is produced at an upper portion of the semiconductor substrate at the neighborhood of the resonator end surface, and in this state respective semiconductor layers are successively grown on the substrate by an MOCVD method, the circulating of material gas into below the overhung portion becomes bad, and the amount of supplied gas thereto is reduced with relative to that to the other portion, and the growth rate of the film becomes slower. Thus, a doublehetero junction structure in which the thicknesses of the respective layers at the neighborhood of the resonator end surface are thinner than those at the inside and central portion of the chip is obtained.

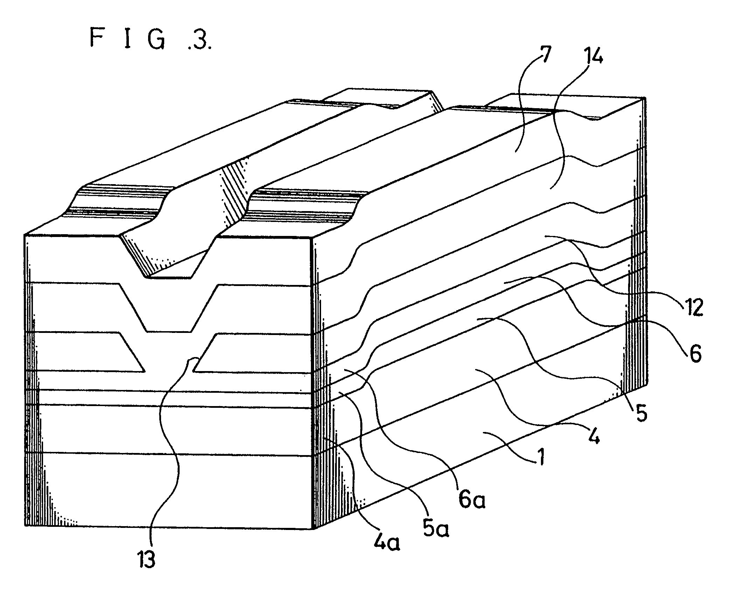

In the above-illustrated embodiment, a semiconductor laser having no mechanism for controlling the transverse mode is described for simplification, but the method of the present invention, of course, may be applied to a semiconductor laser having the same. Another embodiment of the present invention of such a structure is shown in figure 3. In figure 3, the reference numeral 12 designates an n type GaAs current blocking layer, the reference numeral 13 designates a stripe groove, and the reference numeral 14 designates a p type $Al_xGa_{1-x}As$ embedded layer.

The production processes of this embodiment are the same up to those of figures 2(a) to (d), and thereafter, an n type GaAs current blocking layer 12 is epitaxially grown, a stripe groove 13 is produced by etching the layer 12, and a p type $Al_xGa_{1-x}As$ embedded layer 14 is epitaxially grown. The productions of the layers 12 and 14 are conducted by an MOCVD method. The processes thereafter are the same as those shown in figure 2(e).

In the structure of this embodiment, the active layer 5 is provided close to the current blocking layer 12 so as to constitute a light waveguide mechanism which enables a transverse mode control. Also the thickness of the active layer is made less at the neighborhood of the resonator end surface than at the inside and central portion of the chip, resulting in the same effects as those of the first embodiment.

As is evident from the foregoing description, according to the present invention, epitaxial growths of a lower cladding layer, an active layer, and an upper cladding layer which constitute a doublehetero junction are successively grown on the substrate by an MOCVD method in a state where an overhung portion of a mask layer is produced at above the semiconductor substrate at the neighborhood of the light emission end surface. Accordingly, the thicknesses of the respective layers at the neighborhood of the resonator end surface are made less than those at the inside and central portion of the chip, and a semiconductor laser having a narrow emission beam, a high output operation, a low threshold current, and a lengthy lifetime is obtained at a high production yield and uniform quality with good reproducibility.

## Claims

1. A method of producing a semiconductor laser comprising process steps conducted as follows : providing a semiconductor substrate (1) ;
growing a support layer (8) upon a surface of said substrate ;
growing a mask layer (9, 10) upon said support layer;
etching said mask layer to leave a remanent portion thereof at at least one position proximate to that position of a light emission end surface of the laser to be produced ;
etching said support layer thereby to leave a part (11) of said remanent portion of the mask layer overhanging said surface of said substrate ; and
growing successively a lower cladding layer (4), an active layer (5) and an upper cladding layer (6) on said substrate by metal-organic chemical vapour deposition, whereby a double-heterojunction structure laser is produced wherein the thickness of each of said lower cladding layer (4a), active layer (5a), and upper cladding layer (6a) is in each respective case less at the light emission end thereof than at the inside and central position of the laser.

2. A method of producing a semiconductor laser as claimed in claim 1, wherein said support layer (8) and said mask layer (9) are each grown by metal-organic chemical vapour deposition.

3. A method of producing a semiconductor laser as claimed in either claims 1 or 2, wherein said mask layer (9) comprises gallium arsenide (GaAs) and is etched by ammonium hydrogen-peroxide water system etchant.

4. A method of producing a semiconductor laser as claimed in any one of the preceding claims, wherein said support layer (8) comprises aluminium gallium arsenide ($Al_xGa_{1-x}As$) and is etched by mixed solution of iodine and potassium iodide.

## Patentansprüche

1. Verfahren zum Herstellen eines Halbleiterlasers mit den wie folgt ausgeführten Verfahrensschritten :
Vorsehen eines Halbleitersubstrates (1) ;
Aufwachsen einer Trägerschicht (8) auf einer Oberfläche des Substrates ;

Aufwachsen einer Maskenschicht (9, 10) auf die Trägerschicht ; Ätzen der Maskenschicht zum Belassen eines verbleibenden Abschnittes davon an mindestens einer Position nahe der Lichtemissionsendoberfläche des herzustellenden Lasers ;
Ätzen der Trägerschicht zum Belassen eines Teiles (11) des verbleibenden Abschnittes der Maskenschicht, der über die Oberfläche des Substrates auskragt ; und
aufeinanderfolgendes Aufwachsen einer unteren Plattierschicht (4), einer aktiven Schicht (5) und einer oberen Plattierschicht (6) auf das Substrat durch metallorganisches chemisches Dampfabscheiden, wodurch ein Doppel-Hetero-Übergangslaser hergestellt wird, bei dem die Dicke von jeder der unteren Plattierschicht (4a), aktiven Schicht (5a) und oberen Plattierschicht (6a) in jedem entsprechenden Fall an dessen Lichtemissionsende geringer ist als an der inneren und zentralen Position des Lasers.

2. Verfahren zum Herstellen eines Halbleiterlasers nach Anspruch 1, bei dem die Trägerschicht (8) und die Maskenschicht (9) je durch metallorganisches chemisches Dampfabscheiden aufgewachsen werden.

3. Verfahren zum Herstellen eines Halbleiterlasers nach Anspruch 1 oder 2, bei dem die Maskenschicht (9) Galliumarsenid (GaAs) aufweist und durch ein Ammoniumwasserstoffperoxidwassersystem als Ätzmittel geätzt wird.

4. Verfahren zum Herstellen eines Halbleiterlasers nach einem der vorhergehenden Ansprüche, bei dem die Trägerschicht (8) Aluminiumgalliumarsenid ($Al_xGa_{1-x}As$) aufweist und durch eine gemischte Lösung von Jod und Kaliumjodid geätzt wird.

**Revendications**

1. Un procédé de fabrication d'un laser à semiconducteurs, comprenant des étapes de traitement qui sont accomplies de la façon suivante :
on fournit un substrat semiconducteur (1) ;
on fait croître une couche de support (8) sur une surface de ce substrat ;
on fait croître une couche de masque (9, 10) sur la couche de support ;
on grave la couche de masque pour laisser une partie restante de celle-ci, dans au moins une position proche de la position d'une surface d'extrémité d'émission de lumière du laser à fabriquer ;
on grave la couche de support, pour laisser ainsi une région (11) de la partie restante de la couche de masque en surplomb sur la surface du substrat ; et
on fait croître successivement une couche de gaine inférieure (4), une couche active (5) et une couche de gaine supérieure (6) sur le substrat, par dépôt chimique en phase vapeur aux organométalliques, grâce à quoi on obtient un laser ayant une structure à double hétérojonction, dans laquelle l'épaisseur de chacune des couches comprenant la couche de gaine inférieure (4a), la couche active (5a) et la couche de gaine supérieure (6a), est dans chaque cas respectif plus faible à l'extrémité d'émission de lumière de la couche considérée que dans la partie intérieure et centrale du laser.

2. Un procédé de fabrication d'un laser à semiconducteurs selon la revendication 1, dans lequel on fait croître la couche de support (8) et la couche de masque (9) par dépôt chimique en phase vapeur aux organométalliques.

3. Un procédé de fabrication d'un laser à semiconducteurs selon l'une quelconque des revendications 1 ou 2, dans lequel la couche de masque (9) consiste en arséniure de gallium (GaAs), et elle est gravée par un agent de gravure consistant en un système ammoniaque/peroxyde d'hydrogène/eau.

4. Un procédé de fabrication d'un laser à semiconducteurs selon l'une quelconque des revendications précédentes, dans lequel la couche de support (8) consiste en arséniure d'aluminium-gallium ($Al_xGa_{1-x}As$), et elle est gravée par une solution en mélange d'iode et d'iodure de potassium.

F I G .1.

EP 0 306 225 B1

F I G .2.

(a)

(b)

(c)

(d)

(e)

EP 0 306 225 B1

F I G .3.

F I G .4.(PRIOR ART)

F I G .5.(PRIOR ART)